Europäisches Patentamt

European Patent Office

Office européen des brevets

(19)

(11) Veröffentlichungsnummer : **0 243 898 B1**

# (12) EUROPÄISCHE PATENTSCHRIFT

(45) Veröffentlichungstag der Patentschrift :
25.09.91 Patentblatt 91/39

(51) Int. Cl.⁵ : **H03F 1/32**

(21) Anmeldenummer : 87106021.6

(22) Anmeldetag : 24.04.87

(54) Schaltung zur Kettenkompensation der Nichtlinearität eines Verstärkers.

(30) Priorität : 02.05.86 DE 3614785

(43) Veröffentlichungstag der Anmeldung :
04.11.87 Patentblatt 87/45

(45) Bekanntmachung des Hinweises auf die
Patenterteilung :
25.09.91 Patentblatt 91/39

(84) Benannte Vertragsstaaten :
DE FR GB IT NL

(56) Entgegenhaltungen :
DE-A- 3 307 309
US-A- 3 732 502
GLOBECOM'82, IEEE GLOBAL TELECOMMU-
NICATIONS CONFERENCE, Miami, 29. November - 2. Dezember 1982, CONFERENCE
RECORD, Band 1 von 3, IEEE, New York, US;
D.R. GREEN, Jr.: "Characterization and compensation of nonlinearities in microwave
transmitters"

(73) Patentinhaber : Rohde & Schwarz GmbH & Co.
KG
Mühldorfstrasse 15
W-8000 München 80 (DE)

(72) Erfinder : Gottwald, Alfons,
Prof.Dr.Ing.Dr.habil
Kirchstrasse 43
W-8213 Sachrang (DE)
Erfinder : Ens, Hermann, Dipl.-Ing. Dr.
Ahornstrasse 30
W-8043 Unterföhring (DE)

(74) Vertreter : Graf, Walter, Dipl.-Ing.
Sckellstrasse 1
W-8000 München 80 (DE)

## Beschreibung

Die Erfindung betrifft eine Schaltung zur Kompensation der Nichtlinearität eines Verstärkers laut Oberbegriff des Hauptanspruches.

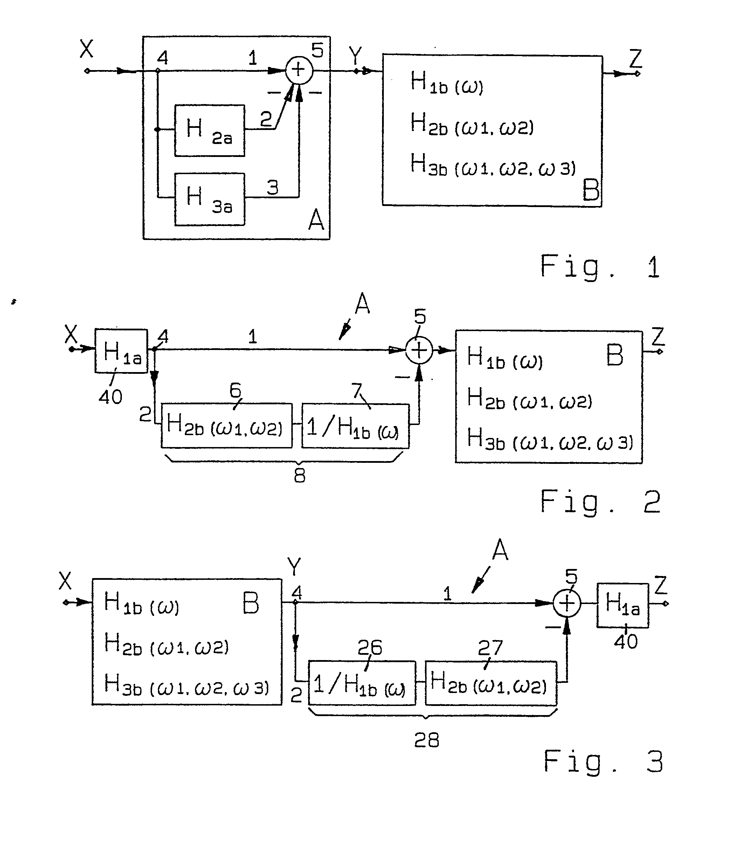

Sus der Literaturstelle Globecom '82, IEEE global Telecommunications Conference, Miami, 29.11.-2.12-1982, Conference Record, Band 1 von 3, IEEE, New York, Seiten 213-217 sind im gegensatz dazu additive Vorverzerrer bekannt, die US-A- 3 732 502 beschreibt Parallelkompensationsschaltungen. Kettenkompensationsschaltungen oder enstgenannten Art sind ebenfalls bekannt (DE-A-21 40 851 bzw. DE-A-23 06 294). Durch das vor oder nach dem Verstärker angeordnete Hilfssystem wird das zu verstärkende Signal soweit wie möglich exakt invers zu den nichtlinearen Verzerrungen des Verstärkers vor- bzw. nachverzerrt, so daß sich die durch den Verstärker verursachten Verzerrungen aufheben. Fig. 1 zeigt das Prinzipschaltbild einer solchen Kettenkompensationsschaltung mit vor dem Verstärker B angeordneten Hilfssystem A. Der Verstärker B besitzt eine frequenzabhängige nichtlineare Übertragungsfunktion mit einem linearen Anteil $H_{1b}(\omega)$, einem quadratischen Anteil $H_{2b}(\omega_1,\omega_2)$ und einem kubischen Anteil $H_{3b}(\omega_1,\omega_2,\omega_3)$. Das Hilfssystem A besteht beispielsweise aus drei Zweigen 1, 2, 3, die parallel zwischen einer Verzweigungsstelle 4 und einer Addierstelle 5 parallelgeschaltet sind. Der Zweig 1 verbindet meist direkt die Verzweigungsstelle 4 mit der Addierstelle 5, zur Kompensation der quadratischen Verzerrungen ist im Zweig 2 eine Schaltungskomponente $H_{2a}$ angeordnet, durch welche das Eingangssignal X quadratisch verzerrt und invers der Addierstelle 5 zugeführt wird. Zur Kompensation von kubischen Verzerrungen kann im Zweig 3 noch eine entsprechende Schaltungskomponente $H_{3a}$ angeordnet sein, die das Eingangssignal X kubisch verzerrt und wiederum invers der Addierstelle 5 zuführt. Bei den bekannten Hilfssystemen sind die Schaltungskomponenten $H_{2a}$ bzw. $H_{3a}$ aus Bauelementen wie Dioden oder Widerstandsnetzwerken aufgebaut, deren Übertragungskennlinien nur bei einer Frequenz in etwa übereinstimmen mit der entsprechenden quadratischen oder kubischen Kennlinie des Verstärkers B bei der gleichen Frequenz, bei den bekannten Schaltungen sind außerdem meist zusätzliche Phasenschieber in den Zweigen 2 und 3 angeordnet, mit denen exakt nur für eine ausgewählte Frequenz die gewünschte Anpassung der Kennlinien zwischen dem Hilfssystem A und dem Verstärker B einstellbar ist. Die bekannten Hilfssysteme sind daher nur Schmalbandlösungen, eine breitbandige Kompensation der Nichtlinearitäten eines solchen Verstärkers in einem breiten Übertragungsfrequenzband ist mit den bekannten Hilfssystemen nicht möglich.

Es ist daher Aufgabe der Erfindung, eine Kettenkompensationsschaltung für Breitbandverstärker und andere frequenzabhängige nichtlineare Übertragungssysteme zu schaffen, die in einem breiten Frequenzband eine Kompensation der Nichtlinearitäten eines solchen Verstärkers oder Übertragungssystems ermöglichen.

Diese Aufgabe wird durch eine Schaltung nach dem Hauptanspruch gelöst. Vorteilhafte Weiterbildungen ergeben sich aus den Unteransprüchen. Bei der erfindungsgemäßen Schaltung erfolgt der Aufbau des Hilfssystemes ausschließlich mit Schaltungskomponenten, deren frequenzabhängige Übertragungsfunktionen im Idealfall bei allen Frequenzen, zumindest jedoch immer im gesamten Übertragungsfrequenzband des zu kompensierenden Verstärkers gleich sind mit den entsprechenden frequenzabhängigen Übertragungsfunktionen des zu kompensierenden Verstärkers, wobei sowohl der quadratische als auch der kubische Kompensationszweig jeweils zusätzlich noch eine Schaltungskomponente enthält, die eine frequenzabhängige Übertragungsfunktion aufweist, welche dem inversen linearen Anteil der frequenzabhängigen Übertragungsfunktion des zu kompensierenden Verstärkers ebenfalls breitbandig im gesamten Übertragungsfrequenzband entspricht. Gemäß der Erfindung werden erstmals prinzipielle Grundschaltungen aufgezeigt, mit denen bausteinartig aus vorgegebenen Schaltungskomponenten ein Hilfssystem zur Kompensation der Nichtlinearitäten eines Verstärkers aufgebaut werden können, die breitbandig im gesamten Übertragungsfrequenzband des Verstärkers diese Kompensation ermöglichen. Die für die Bemessung der einzelnen Schaltungskomponenten des Hilfssystems erforderlichen Daten für die linearen, quadratischen bzw. kubischen Anteile der frequenzabhängigen Übertragungsfunktion des zu kompensierenden Verstärkers einschließlich der zugehörigen Faltungsoperationen im Frequenzbereich können in bekannter Weise entweder berechnet werden (beispielsweise nach H.J. Butterweck, Frequenzabhängigkeit nichtlinearer Übertragungssysteme, AEÜ 21, 1967, S. 239-254) oder sie können unmittelbar von dem zu kompensierenden Verstärker durch Messen abgeleitet und bestimmt werden.

Auf diese Weise ist es möglich, beispielsweise den breitbandigen Leistungsverstärker eines Fernsehsenders breitbandig zu kompensieren, so daß er in einem breiten Frequenzband extrem lineare Verstärkungseigenschaften aufweist. Besonders einfach wird der Aufbau, wenn im Hilfssystem jeweils Verstärkerelemente wie Transistoren und dergleichen eingesetzt werden, die baugleich mit den entsprechenden Verstärkerelementen des zu kompensierenden Verstärkers sind. Nachdem der lineare Übertragungsfaktor des Hilfssystems frei wählbar ist, kann auch das Hilfssystem selbst als breitbandiger Vorverstärker ausgebildet werden.

Die Erfindung wird im folgenden anhand schematischer Zeichnungen an Ausführungsbeispielen näher erläutert.

Fig. 2 und 3 zeigen das Prinzipschaltbild einer Schaltung zur Kompensation von ausschließlich quadratischen Nichtlinearitäten eines Verstärkers,

Fig. 4 und 5 zeigen eine Schaltung zur Kompensation von ausschließlich kubischen Nichtlinearitäten eines Verstärkers.

Fig. 6 bis 11 zeigen Schaltungen zur Kompensation sowohl der quadratischen als auch der kubischen Nichtlinearitäten eines Verstärkers.

Fig. 12 bis 14 zeigen Möglichkeiten für die Realisierung der im Hilfssystem nach den Fig. 2 bis 11 benutzten Schaltungskomponenten mit quadratischer bzw. kubischer Übertragungsfunktion.

Fig. 15 und 16 zeigen das Prinzipschaltbild eines zu kompensierenden Transistorverstärkers einschließlich des zugehörigen Ersatzschaltbildes sowie die zugehörige gemessene bzw. errechnete frequenzabhängige nichtlineare Übertragungsfunktion.

Fig. 17 zeigt ein Ausführungsbeispiel für den Aufbau eines Hilfssystems zur Kompensation eines solchen Verstärkers nach Fig. 15.

Fig. 18 zeigt schematisch die bekannten Regeln zum Vertauschen sowie Verschieben von linearen Schaltungskomponeten über Verzweigungsstellen und Additionsstellen, wie sie beim erfindungsgemäßen Hilfssystem anwendbar sind.

In der nachfolgenden Beschreibung wird grundsätzlich zwischen zwei Fällen unterschieden. Im Fall 1 ist das Hilfssystem A vor dem zu kompensierenden Verstärker B angeordnet, wie dies die Fig. 2, 4, 6, 7, 11 zeigen, im Fall 2 ist dagegen das Hilfssystem A nach dem zu kompensierenden Verstärker B angeordnet, wie dies die Fig. 3, 5, 8, 9 und 10 zeigen. Der Fall 1 wird hauptsächlich bei Endverstärkerstufen angewendet, der Fall 2 bei Eingangsverstärkerstufen.

In den nachfolgenden Gleichungen und Figuren bedeutet der Index a jeweils die Zuordnung zum Hilfssystem A während der Index b jeweils die Zuordnung zu dem zu kompensierenden Verstärker B bedeutet.

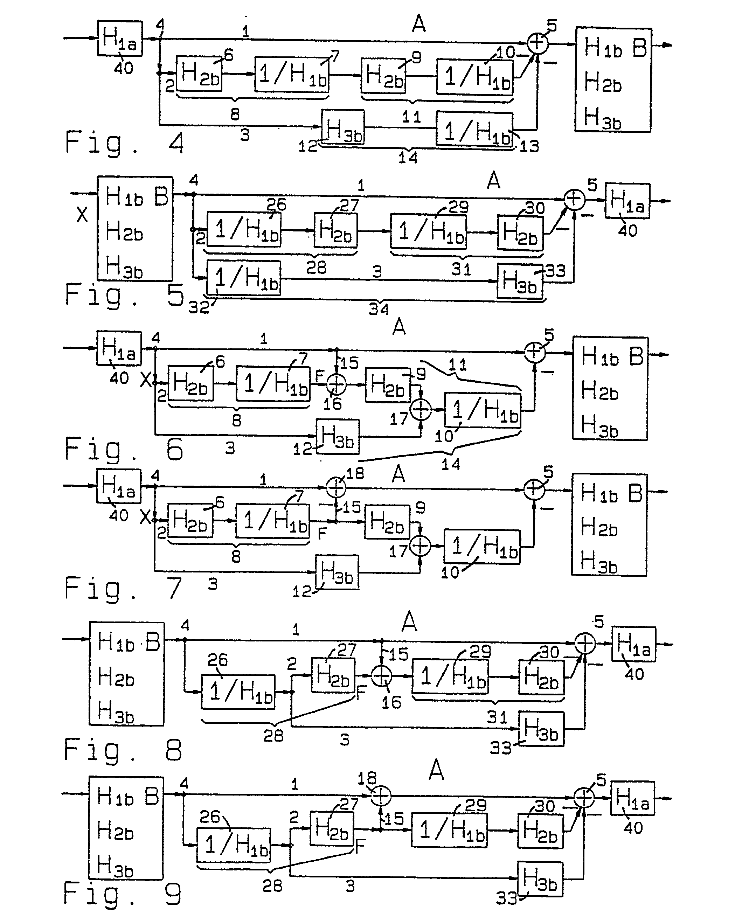

Unter dem Begriff "linearer, quadratischer oder kubischer Anteil der frequenzabhängigen Übertragungsfunktion des zu kompensierenden Verstärkers" wird nachfolgend die entsprechende Übertragungsfunktion bei allen möglichen Frequenzen verstanden, zumindest jedoch bei all denjenigen Frequenzen, die innerhalb des Übertragungsfrequenzbandes des zu kompensierenden Verstärkers B liegen, wenn möglich jedoch zusätzlich auch noch die oberhalb und unterhalb der Frequenzgrenzen dieses Frequenzbandes liegenden Frequenzen. Die auf diese Weise breitbandig im Idealfall bei allen Frequenzen bestimmten Übertragungsfunktionen des Verstärkers B werden nachfolgend mit $H_{1b}(\omega)$, $H_{2b}(\omega_1,\omega_2)$ bzw. $H_{3b}(\omega_1,\omega_2,\omega_3)$ bezeichnet, wie dies auch in den Fig. 2 und 3 eingezeichnet ist, in den anschließenden Figuren 4 bis 11 ist der Einfachheit halber die an sich das Breitbandige anzeigende Bezeichnung $(\omega)$ weggelassen, obwohl auch hier im Gegensatz zu der schmalbandigen bekannten Lösung nach Fig. 1 die entsprechenden Schaltungskomponenten bei allen Frequenzen zumindest innerhalb des Frequenzbandes des Verstärkers B die entsprechende Übereinstimmung mit den Übertragungsfunktionen des Verstärkers B besitzen.

Ein nichtlineares frequenzabhängiges Übertragungssystem kann durch eine Volterra-Reihe im Zeitbereich beschrieben werden. Eine Beschreibung im Frequenzbereich ist nach Chua, L.O.; Ng, C.Y.: "Frequency domain analysis of nonlinear systems: General theory", IEE J. Electronic Circuits and Systems, vol. 3, no. 4, 1979, durch die Fouriertransformierten der Glieder dieser Volterra-Reihe $H_1(\omega_1)$, $H_2(\omega_1, \omega_2)$, $H_3(\omega_1,\omega_2,\omega_3)$... möglich. Das Spektrum $Y(\omega)$ des Ausgangssignals eines frequenzabhängigen nichtlinearen Systems ergibt sich in Abhängigkeit vom Eingangsspektrum $X(\omega)$ zu:

$$Y(\omega) = H_1(\omega) \cdot X(\omega) + H_2(\omega_1,\omega_2) \cdot (X(\omega) * X(\omega)) + \qquad (1)$$
$$+ H_3(\omega_1,\omega_2,\omega_3) \cdot (X(\omega) * X(\omega) * X(\omega)) + \ldots$$

Hierbei ist "*" das Faltungssymbol: Es verlangt die Faltung der beteiligten Größen im Frequenzbereich. $\omega$, $\omega_1$, $\omega_2$, $\omega_3$ sind als variable Kreisfrequenzen zu verstehen. Die drei Summanden $H_1(\omega)$, $H_2(\omega_1, \omega_2)$ und $H_3(\omega_1,\omega_2,\omega_3)$ des Ausgangsspektrums werden als linearer, quadratischer und kubischer Anteil der Übertragungsfunktionen des frequenzabhängigen nichtlinearen Systems bezeichnet. Bei praktischen Systemen können Nichtlinearitäten höherer als dritter Ordnung in der Regel vernachlässigt werden. Für die erfindungsgemäße Realisierung des Hilfssystems werden deshalb nur quadratische und kubische Nichtlinearitäten berücksichtigt; sämtliche Darstellungen sind nur bis zum dritten Glied ausgeführt. Durch Kettenschaltung zweier nichtlinearer frequenzabhängiger Übertragungssysteme nach Fig. 1 ergeben sich für die Gesamtübertragungsfunktion von X nach Z (z.B. nach K. Fastenmeier: "Die Frequenzabhängigkeit nichtlinearer Vorgänge in Transistorschaltungen", Dissertation TU München, 1974): für den linearen Anteil der Übertragungsfunktion:

$$H_1(\omega_1) = H_{1a}(\omega_1) \cdot H_{1b}(\omega_1): \quad (2)$$

für den quadratischen Anteil der Übertragungsfunktion:

$$H_2(\omega_1,\omega_2) = H_{2a}(\omega_1,\omega_2) \cdot H_{1b}(\omega_1+\omega_2) + \qquad (3)$$

$$+ H_{1a}(\omega_1) \cdot H_{1a}(\omega_2) \cdot H_{2b}(\omega_1,\omega_2);$$

für den kubischen Anteil der Übertragungsfunktion:

$$H_3(\omega_1,\omega_2,\omega_3) = H_{3a}(\omega_1,\omega_2,\omega_3) \cdot H_{1b}(\omega_1+\omega_2+\omega_3) + \qquad (4)$$

$$+ H_{1a}(\omega_1) \cdot H_{1a}(\omega_2) \cdot H_{1a}(\omega_3) \cdot H_{3b}(\omega_1,\omega_2,\omega_3) +$$

$$+ \frac{2}{3} \sum_{\xi,\eta,\delta}^{3} H_{1a}(\omega_\xi) \cdot H_{2a}(\omega_\eta,\omega_\delta) \cdot H_{2b}(\omega_\xi,\omega_\eta+\omega_\delta);$$

Das Zeichen

$$\sum_{\xi,\eta,\delta}^{3}$$

bedeutet, daß in den drei Summanden $\xi$, $\eta$, und $\delta$ permutierend die Werte 1, 2 und 3 annehmen.

Die Erfindung geht nun von folgenden Überlegungen aus: Damit die Kettenschaltung der beiden Systeme A und B keine quadratischen Verzerrungen verursacht, ist die Bedingung:

$$H_2(\omega_1,\omega_2) = 0 \quad (5)$$

zu erfüllen. Daraus wurden die elementaren Bedingungen für die breitbandige Kompensation quadratischer Verzerrungen gemäß den Gleichungen (7) und (9) gewonnen. Damit die Kettenschaltung der beiden Systeme A und B keine kubischen Verzerrungen verursacht, ist die Bedingung

$$H_3(\omega_1,\omega_2,\omega_3) = 0 \quad (6)$$

zu erfüllen. Daraus wurden die elementaren Bedingungen für die breitbandige Kompensation kubischer Verzerrungen gemäß den Gleichungen (8) und 10) gewonnen.

Für den Fall 1 (A vor B) ergeben sich daraus folgende Vorschriften für das Hilfssystem:

$$H_{2a}(\omega_1,\omega_2) = -\frac{H_{1a}(\omega_1) \cdot H_{1a}(\omega_2) \cdot H_{2b}(\omega_1,\omega_2)}{H_{1b}(\omega_1+\omega_2)}; \quad (7)$$

$$H_{3a}(\omega_1,\omega_2,\omega_3) = -\frac{H_{1a}(\omega_1) \cdot H_{1a}(\omega_2) \cdot H_{1a}(\omega_2) \cdot H_{3b}(\omega_1,\omega_2,\omega_3)}{H_{1b}(\omega_1+\omega_2+\omega_3)} -$$

$$\qquad (8)$$

$$-\frac{2}{3} \sum_{\xi\ \eta\ \delta}^{3} \frac{H_{1a}(\omega_\xi) \cdot H_{2a}(\omega_\eta,\omega_\delta) \cdot H_{2b}(\omega_\xi,\omega_\eta+\omega_\delta)}{H_{1b}(\omega_1+\omega_2+\omega_3)};$$

Für den Fall 2 (A nach B) ergeben sich folgende Vorschriften für das Hilfssystem:

$$H_{2a}(\omega_1,\omega_2) = \frac{H_{1a}(\omega_1+\omega_2) \cdot H_{2b}(\omega_1,\omega_2)}{H_{1b}(\omega_1) \cdot H_{1b}(\omega_2)}; \quad (9)$$

$$H_{3a}(\omega_1,\omega_2,\omega_3) = -\frac{H_{1a}(\omega_1+\omega_2+\omega_3)\cdot H_{3b}(\omega_1,\omega_2,\omega_3)}{H_{1b}(\omega_1)\cdot H_{1b}(\omega_2)\cdot H_{1b}(\omega_3)} - \qquad (10)$$

$$-\frac{2}{3}\frac{\sum\limits_{\xi,\eta,\delta}^{3}H_{1b}(\omega_\xi)\cdot H_{2b}(\omega_\xi,\omega_\delta)\cdot H_{2a}(\omega_\xi,\omega_\eta+\omega_\delta)}{H_{1b}(\omega_1)\cdot H_{1b}(\omega_2)\cdot H_{1b}(\omega_3)};$$

Diese Gleichungen 7, 8, 9 und 10 können in entsprechende elektrische Blockschaltungen umgesetzt werden. Fig. 2 zeigt die Umsetzung der Gleichung 7, wobei sich aus der Komponente $(\omega_1+\omega_2)$ des Nenners ergibt, daß die Schaltungskomponente 7 mit inverser linearer Übertragungsfunktion nach der Schaltungskomponente 6 mit quadratischer Nichtlinearität angeordnet sein muß. Fig. 3 zeigt die entsprechende Realisierung der Gleichung 9, wobei sich wiederum aus dem Nenner dieser Gleichung ergibt, daß in diesem Fall die invers-lineare Komponente 26 vor der quadratischen Schaltungskomponente 27 angeordnet sein muß.

Die Fig. 4 und 5 zeigen jeweils die Realisierung der Gleichungen 8 bzw. 10, nach Fig. 4 besteht der zweite Zweig 2 aus zwei in Kette geschalteten Kettengliedern 8 und 11, die jeweils aufgebaut sind aus einer Schaltungskomponente 6 bzw. 9 mit quadratischer Übertragungsfunktion und einer nachgeschalteten Schaltungskomponente 7 bzw. 10 mit invers-linearer Übertragungsfunktion. Der Zweig 3 enthält ein Kettenglied 14 bestehend aus der Kettenschaltung einer Schaltungskomponente 12 mit kubischer Übertragungsfunktion und einer nachgeschalteten Schaltungskomponente 13 mit inverser linearer Übertragungsfunktion. Die Lösung für den Fall 2 gemäß Fig. 5 besitzt im Zweig 2 zwei in Kette geschaltete Kettenglieder 28 und 31, der Zweig 3 enthält ein Kettenglied 34, wobei die Kettenglieder jeweils wiederum aus Schaltungskomponenten 27, 30 mit quadratischer Übertragungsfunktion bzw. einer Schaltungskomponente 33 mit kubischer Übertragungsfunktion aufgebaut sind, in diesem Fall jedoch mit jeweils vorgeschalteten Schaltungskomponenten 26, 29, 32 mit jeweils inverser linearer Übertragungsfunktion. Die Ausgänge der Zweige 2 und 3 werden jeweils invers der Addierstelle 5 zugeführt (angedeutet durch das Minuszeichen).

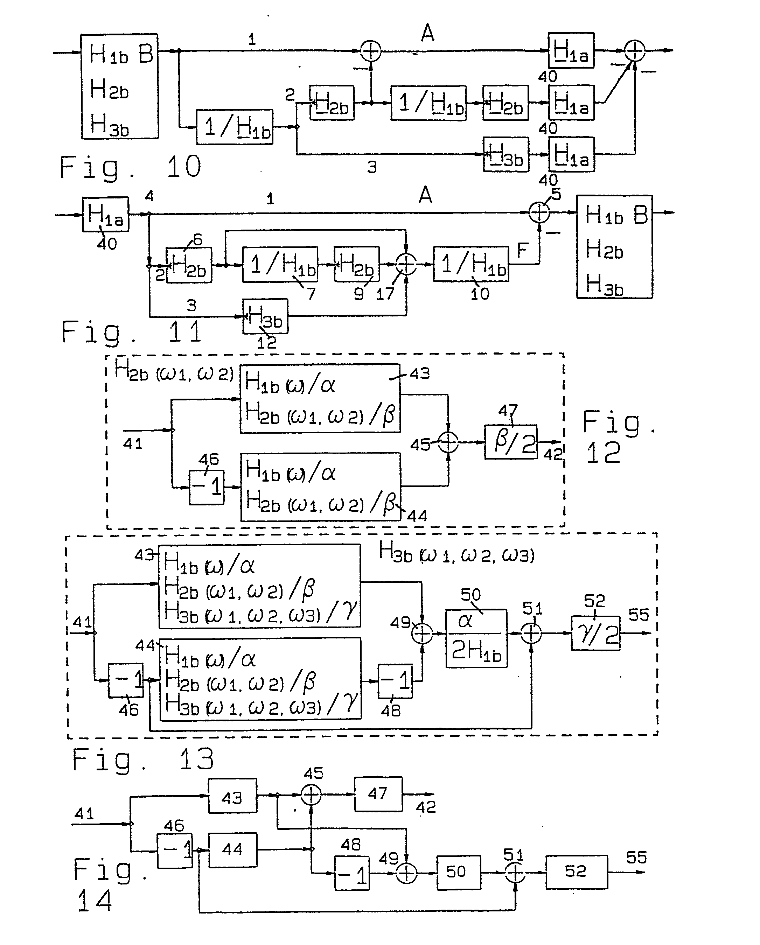

Die Schaltbilder 6 bis 9 zeigen die kombinierte Realisierung der Gleichungen 7 bis 10, also für die Kompensation sowohl von quadratischen als auch von kubischen Verzerrungen. Die Schaltbilder nach den Fig. 6 bis 9 entsprechen im wesentlichen den Schaltbildern nach den Fig. 4 und 5, hier sind lediglich zur Vereinfachung des Aufbaus die in den Fig. 4 und 5 noch jeweils gesonderten Schaltungskomponenten 10, 13 bzw. 26, 32 für beide Zweige 2 und 3 zusammengefaßt zu einer einzigen Schaltungskomponente 10 (Fig. 6 und 7) bzw. 26 (Fig. 8 und 9). In den Figuren 6 und 7 ist hierzu noch eine zusätzliche Addierstufe 17 vorgesehen, die die Ausgangssignale der Schaltungskomponenten 9 und 12 zusammenfaßt. Die gleiche Zusammenfassung könnte selbstverständlich auch bei den Prinzipschaltbildern nach den Fig. 4 und 5 angewendet werden.

Für die zusätzliche quadratische Kompensation ist bei den Grundschaltungen nach den Fig. 6 bis 9 noch eine Querverbindung 15 zwischen dem Zweig 1 und dem Zweig 2 vorgesehen, durch welche entweder dem Ausgangssignal F des ersten Kettengliedes 8 das Eingangssignal X von der Verzweigungsstelle 4 linear mit dem Verstärkungsfaktor 1 hinzuaddiert wird (X + F), wie dies die Figuren 6 und 8 mit der zusätzlichen Addierstufe 16 vor dem zweiten Kettenglied 11 bzw. 31 zeigen, oder das Ausgangssignal F dieses ersten Kettengliedes 8 bzw. 28 wird über eine zusätzliche Addierstufe 18 im ersten Zweig 1 von dem Eingangssignal X der Verzweigungsstelle subtrahiert (X - F), wie dies wiederum durch das Minus-Zeichen der Addierstufe 18 angedeutet ist.

Wie aus Gl. (1) hervorgeht, enthalten die nichtlinearen Komponenten $^*H_{2b}$ und $^*H_{3b}$ nicht, wie in Blockschaltbildern bisweilen üblich, nur multiplikative Gewichtsfunktionen, sie beinhalten auch Faltungsoperationen gemäß Gleichung (1). Dies ist mit ein Grund dafür, weshalb die allgemein bekannten Regeln für das Verschieben von Blöcken über Verzweigungs- und Additionsstellen sowie das Vertauschen von Blöcken (vgl. Fig. 19) auf die nichtlinearen Schaltungskomponenten nicht angewendet werden dürfen. Mit den Strukturen für das Hilfssystem nach Fig. 2 bis 9 sind Anordnungen gefunden worden, die den minimal nötigen Aufwand darstellen, um die frequenzabhängige Nichtlinearität in einem weiten Frequenzbereich exakt zu kompensieren. Für die linearen Subsysteme $1/H_{1b}$ und $H_{1a}$ gelten natürlich die oben erwähnten aufgezeigten Regeln zur Modifizierung von Blockschaltbildern. Deshalb ist es möglich, durch Verschieben sowie Vertauschen der linearen Blöcke zu einer Vielfalt von Lösungsmöglichkeiten zu gelangen, die allerdings alle auf die Strukturen in den Fig. 2 - 9 zurückzuführen sind.

Eine solche Modifikation ist beispielsweise die obenerwähnte Zusammenfassung der in den Fig. 4 und 5 noch getrennt in den Zweigen 2 und 3 dargestellten Schaltungskomponenten 10,13 bzw. 26,32 zu nur einer für beide Zweige 2 und 3 gemeinsamen Schaltungskomponente 10 bzw. 26. Eine weitere Modifikation für die kombinierte quadratische und kubische Kompensation zeigt Fig. 11. Hier wird die anhand der Fig. 7 beschriebene Forderung (X - F) dadurch erfüllt, daß das Ausgangssignal der Schaltungs-komponente 6 der Addierstufe 17 zugeführt wird und damit am Ausgang der Schaltungskomponente 10 wiederum das Ausgangssignal F entsteht, das dann in der Addierstufe 5 von dem Eingangssignal X subtrahiert wird.

Aus den Gleichungen 7 bis 9 ergibt sich, daß dem Hilfssystem auch noch eine zusätzliche Schaltungskomponente mit beliebiger linearer Übertragungsfunktion $H_{1a}(\omega)$ vor-bzw. nachgeschaltet werden kann. Dies ist in den Ausführungsbeispielen nach den Fig. 2 bis 9 und 11 jeweils durch eine entsprechende zusätzliche Schaltungskomponente 40 angedeutet. Fig. 10 zeigt in dieser Beziehung eine weitere Modifikation der Grundschaltung nach Fig. 9, hier ist in jedem der Zweige 1, 2, 3 jeweils eine eigene lineare Schaltungskomponente 40 angeordnet.

Aus den Grundschaltungen nach den Fig. 2 bis 9 bzw. den Modifikationen nach den Fig. 10 und 11 ergibt sich, daß das Hilfssystem A sehr einfach und übersichtlich aus Schaltungskomponenten aufgebaut werden kann, die nur so ausgewählt und dimensioniert werden müssen, daß sie jeweils das entsprechende gleiche breitbandige Übertragungsverhalten besitzen wie der zu kompensierende Verstärker B. Es ist hierzu nur erforderlich, den linearen, quadratischen bzw. kubischen Anteil der frequenzabhängigen Übertragungsfunktion $H_{1b}(\omega)$, $H_{2b}(\omega_1,\omega_2)$ bzw. $H_{3b}(\omega_1,\omega_2,\omega_3)$ des zu kompensierenden Verstärkers B breitbandig, zumindest jedoch in dem Übertragungsfrequenzband des breitbandigen Verstärkers B in bekannter Weise zu berechnen oder unmittelbar durch Messen am Verstärker B zu bestimmen. Mit diesen so errechneten oder gemessenen Werten können dann die einzelnen Schaltungskomponenten auf einfache Weise aus Bauelementen, welche diese Übertragungsfunktionen besitzen, aufgebaut und im Sinne der erfindungsgemäßen Grundschaltungen zusammengebaut werden.

Für den Aufbau und die Realisierung der Schaltungskomponenten des Hilfssystems A aufbauend auf den gemessenen oder berechneten Werten des Verstärkers B gibt es die verschiedensten Möglichkeiten. Die Schaltungskomponenten mit inverser linearer Übertragungsfunktion $1/H_{1b}(\omega)$ werden wegen der geforderten Linearität am einfachsten mit passiven Schaltungselementen realisiert. Eine weitere Möglichkeit ist die Realisierung mit Verstärkerschaltungen, die ihrerseits durch bekannte Kompensationsmaßnahmen linearisiert sind.

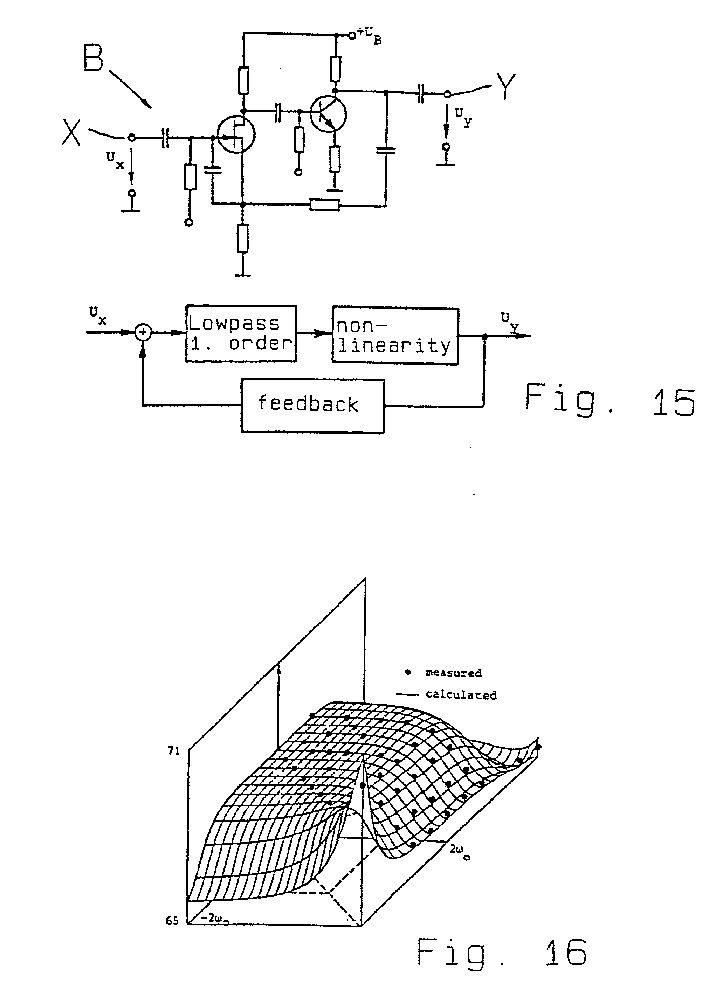

Die Schaltungskomponenten mit quadratischer Übertragungsfunktion $H_{2b}(\omega_1,\omega_2)$ werden vorzugsweise nach Fig. 12 realisiert, die Schaltungskomponenten mit kubischer Übertragungsfunktion $H_{3b}(\omega_1,\omega_2,\omega_3)$ nach Fig. 13.

Für ein System, das mit dem Eingangsspektrum -$X(\omega)$ angeregt wird, ergibt sich nach Gleichung (1) folgendes Ausgangsspektrum $\underline{Y}^{-}(\omega)$:

$$\underline{Y}^{-}(\omega) = -H_1(\omega)X(\omega) + H_2(\omega_1,\omega_2) \cdot (X(\omega) * X(\omega)) -$$

$$-H_3(\omega_1,\omega_2,\omega_3) \cdot (X(\omega) * X(\omega) * X(\omega)) \ldots, \tag{11}$$

Die Anteile mit ungeradem Grad des Ausgangsspektrums werden also invertiert. Durch Addition der Gleichungen (1) und 11) wird der quadratische Anteil der Übertragungsfunktion des betrachteten Systems gewonnen, durch Subtraktion der Gleichungen (1) und (11) und anschließende weitere Subtraktion des Eingangsspektrums $X(\omega)$ wird der kubische Anteil der Übertragungsfunktion des betrachteten Systems gewonnen. Danach arbeiten die Blockschaltungen nach Fig. 12, 13 und 14. Hierbei weisen die nichtlinearen Anteile der Übertragungsfunktionen der Blöcke 43 und 44 gleiche Frequenzabhängigkeit auf wie die nichtlineare Übertragungsfunktion des zu entzerrenden Verstärkers B selbst. Dies schließt ein, daß in den Blöcken 43 und 44 Schaltungen eingesetzt werden können, deren Übertragungsverhalten demjenigen des zu entzerrenden Verstärkers B gleicht, z.B. indem sie baugleich realisiert werden. Für den Fall, daß bei einem zu entzerrenden Verstärker der quadratische oder kubische Anteil der Übertragungsfunktion vernachlässigt werden kann, genügt es, in einem der Blöcke 43 oder 44 nur den linearen Anteil der frequenzabhängigen nichtlinearen Übertragungsfunktion des jeweils anderen Blocks 44 oder 43 zu realisieren. Die Blöcke 47 und 52 werden benögigt, damit konstante Faktoren, um die sich der quadratische bzw. kubische Anteil der Übertragungsfunktion der Blöcke 43 und 44 von denen des zu entzerrenden Verstärkers B unterscheiden, ausgeglichen werden können. Werden in den Blöcken 43 und 44 Verstärker eingesetzt, die mit dem zu entzerrenden Verstärker B baugleich sind, so müssen die Blöcke 47 und 52 jeweils eine lineare Übertragungsfunktion mit dem Wert $+\frac{1}{2}$ aufweisen. Diese

kann auf sehr einfache Weise mit Spannungs- bzw. Stromteilern realisiert werden.

Bei der Schaltung nach Fig. 12 zu Realisierung von $H_{2b}(\omega_1,\omega_2)$ sind beispielsweise zwei Verstärker 43 und 44 zwischen dem Eingang 41 und einer Addierstufe 45 parallelgeschaltet, wobei dem einen Verstärker 44 noch ein Inverter 46 vorgeschaltet ist. Mit den Faktoren $1/\alpha$ und $1/\beta$ ist angedeutet, daß die Bauelemente der Verstärker 43 und 44 nicht baugleich sind mit dem Verstärker B, sondern daß sich der lineare Anteil $H_{1b}(\omega)$ um den Faktor $1/\alpha$ und der quadratische Anteil $H_{2b}(\omega_1,\omega_2)$ um den Faktor $1/\beta$ unterscheiden. Der Faktor $\alpha$ hebt sich in dieser Schaltung auf und kann unberücksichtigt bleiben. Der Faktor $1/\beta$ muß dagegen in der nachfolgenden Schaltung 47 entsprechend berücksichtigt und kompensiert werden. Die Schaltung 47 bewertet daher das Ausgangssignal der Addierstufe 45 mit dem Faktor $\beta/2$. Die Faktoren $\alpha$ und $\beta$ können positive oder negative von 1 verschiedene Zahlenwerte sein. Wenn die Verstärker 43, 44 baugleich mit dem Verstärker B sind, sind diese Faktoren 1.

Falls die kubischen Verzerrungen des Verstärkers B vernachlässigt werden können, genügt es, in einer der beiden Verstärker 43 bzw. 44 nur den linearen Anteil der Übertragungsfunktion des jeweils anderen Verstärkers 44, bzw. 43 zu realisieren. In diesem Fall wird in der Schaltung 47 nur mit dem Faktor $\beta$ verstärkt.

Fig. 13 zeigt eine Schaltung zur Realisierung der Schaltungskomponente $H_{3b}(\omega_1,\omega_2,\omega_3)$. Auch hier werden wieder zwei gleiche Verstärker 43, 44 benutzt, die parallelgeschaltet sind, wobei vor und nach dem Verstärker 44 jeweils ein Inverter 46 bzw. 48 angeordnet ist. Das in der Addierstufe 49 addierte Summensignal wird einer Schaltungskomponente 50 zugeführt, die eine Übertragungsfunktion $\alpha/2H_{1b}(\omega_1,\omega_2)$ besitzt. Das Ausgangssignal des ersten Inverters 46 wird in einer Addierstufe 51 mit dem Ausgangssignal dieser Schaltungskomponente 50 addiert und schließlich in einer Schaltungskomponente 52 mit dem Faktor $\gamma/2$ bewertet, wobei $1/\gamma$ bei der Faktor ist, um den die kubische Komponente der Verstärker 43, 44 von derjenigen des Verstärkers B unterschiedlich ist. Wenn die quadratischen Verzerrungen des Verstärkers B vernachlässigt werden dürfen, genügt es bei dieser Schaltung nach Fig. 13, in einem der beiden Verstärker 43 bzw. 44 nur den linearen Anteil der frequenzabhängigen Übertragungsfunktion des jeweils anderen Verstärkers 44 bzw. 43 zu realisieren. In diesem Fall ist in der Schaltung 52 das addierte Signal nur mit dem Faktor $\gamma$ zu bewerten.

Fig. 14 zeigt schließlich noch die kombinierte Realisierung von $H_{2b}(\omega_1,\omega_2)$ und $H_{3b}(\omega_1,\omega_2,\omega_3)$ aufgebaut aus den Schaltungskomponenten nach den Fig. 12 und 13.

In den Fig. 15 bis 17 wird ein praktisches Ausführungsbeispiel für die Realisierung eines Hilfssystems A zur Kompensation der quadratischen Verzerrungen eines Verstärkers B aufgezeigt, das nach dem obenerwähnten erfindungsgemäßen Grundprinzip aufgebaut ist. Für dieses praktische Ausführungsbeispiel wird ein Verstärker B gewählt, der mit Feldeffekttransistoren nach Fig. 15 aufgebaut ist und der das charakteristische frequenzabhängige nichtlineare Übertragungsverhalten eines Grad 1-Tiefpaßverstärkers mit Gegenkopplung besitzt, wie dies das Ersatz-Schaltbild nach Fig. 15 zeigt. Durch Messen der frequenzabhängigen Verstärkung und des frequenzabhängigen Intermodulationsverhaltens dieses Verstärkers wurde die Übertragungsfunktion $H_{1b}(\omega)$ und $H_{2b}(\omega_1,\omega_2)$ näherungsweise bestimmt. Fig. 16 zeigt den Intermodulationsabstand zweiter Ordnung in Abhängigkeit von der Frequenz, wie dies einerseits durch Messung nach dem Zweiton-Verfahren ermittelt wurde und wie dies andererseits in an sich bekannter Weise durch Modellrechnung ermittelt wurde. Fig. 16 zeigt, daß diese Ermittlung der Parameter durch Rechnung bzw. durch Messung in der Praxis relativ gut übereinstimmt.

Nachdem für das praktische Ausführungsbeispiel der Einfachheit halber nur die Kompensation der quadratischen Verzerrungen gefordert ist, wird als Hilfssystem A zur Kompensation dieses Verstärkers nach Fig. 15 eine Grundschaltung nach Fig. 2 benutzt, die aus Komponenten nach Fig. 12 aufgebaut wird .

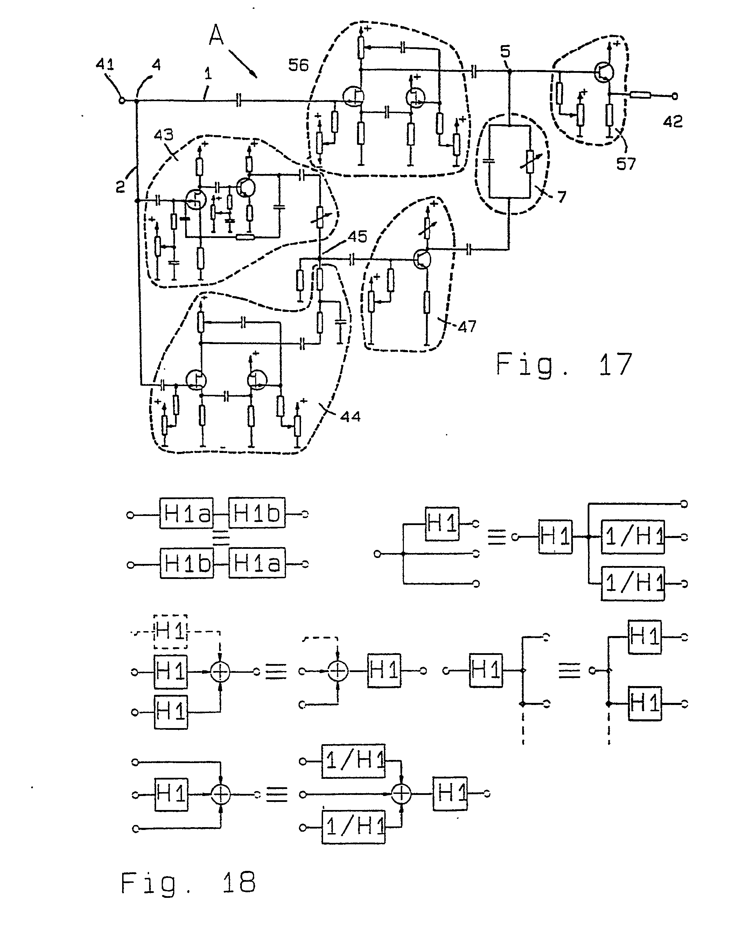

Nach Fig. 17 wird ein Verstärker 43 eingesetzt, der die gleiche Schaltungsstruktur wie der Verstärker B aufweist, allerdings wird dieser Verstärker 43 bei geringen Ruheströmen betrieben. Er weist dadurch zwar quantitativ ein anderes Übertragungsverhalten als der Verstärker B auf, aber doch nahezu gleiche Frequenzabhängigkeit des Übertragungsverhaltens. Als Verstärker 44 wird eine Verstärkerschaltung eingesetzt, die durch Rückkopplungskompensation linearisiert ist und deren Verstärkung variiert werden kann, ohne daß wesentliche Einbußen an der Qualität der Kompensation zu befürchten sind. Auf diese Weise kann das Hilfssystem abgeglichen werden. Es wird also die im Zusammenhang mit Fig. 12 erwähnte Vereinfachung angenommen, nämlich daß kubische Verzerrungen des Verstärkers B vernachlässigt werden dürfen und somit im Verstärker 44 nur der lineare Anteil der Übertragungsfunktion des anderen Verstärkers 44 nachgebildet wird.

Im Zweig 1 ist bei diesem Ausführungsbeispiel zur Entkopplung noch ein zusätzlicher Puffer-Verstärker 56 angeordnet, wodurch die Funktionsweise der Grundschaltung nicht beeinträchtigt wird, dieser Puffer-Verstärker 56 kann sogar als linearer Inverter ausgebildet sein, da bei der Grundschaltung nach Fig. 2 (nicht jedoch bei den anderen Grundschaltungen) das Eingangssignal X auch invertiert der Addierstufe 5 zugeführt werden kann, wie sich dies aus den obigen Gleichungen ergibt.

Die Schaltung 47 ist durch einen einzelnen Transistor realisiert, der bei hohem Ruhestrom betrieben wird und stark gegengekoppelt ist. Er weist deshalb nur geringe Nichtlinearität auf. Zudem wird er nur mit kleinen Signalen - den extrahierten Verzerrungsprodukten - angesteuert. Seine Nichtlinearität ist deshalb kaum wirksam.

Die inverse lineare Schaltungskomponente $1/H_{1b}(\omega)$ ist passiv mit einem RC-Glied in Verbindung mit den angrenzenden Widerständen realisiert. Die Schaltung 57 ist nur ein Impedanzwandler.

Vergleichsmessungen zwischen einer erfindungsgemäßen Schaltung nach Fig. 17 mit einem bekannten Hilfssystem nach Fig. 1, das mit ähnlichen Schaltungskomponenten aufgebaut wurde, ergaben, daß mit einer erfindungs- gemäßen Schaltung in einem breiten Frequenzband sowohl bei tiefen Frequenzen als auch bei mittleren und hohen Frequenzen eine gute Linearisierung des Verstärkers B erreicht wird während dies mit einem bekannten System nur sehr schmalbandig für tiefe Frequenzen möglich ist.

Fig. 18 zeigt schematisch die bekannten Regeln zum Vertauschen von linearen Schaltungskomponenten oder zu deren Verschieben über Verzweigungsstellen oder über Additionsstellen, wie sie auch bezüglich der linearen Schaltungskomponenten bei den erfindungsgemäßen Grundschaltungen angewendet werden können, nicht jedoch bei den quadratischen bzw. kubischen Schaltungskomponenten.

## Patentansprüche

1. Schaltung zur Kompensation der Nichtlinearität eines Verstärkers (B) mit einem vorgeschalteten oder einem nachgeschalteten Hilfssystem (A), bestehend aus einem ersten Zweig (1), der das Eingangssignal (X) von einer Verzweigungsstelle (4) linear und mit dem Verstärkungsfaktor 1 zu einer Addierstelle (5) überträgt, einem zweiten Zweig (2), der das Eingangssignal (X) von der Verzweigungsstelle (4) mit quadratischer Verzerrung invertiert zur Addierstelle (5) überträgt, und/oder einem dritten Zweig (3),der das Eingangssignal (X) von der Verzweigungsstelle (4) mit kubischer Verzerrung invertiert zur Addierstelle (5) überträgt, dadurch **gekennzeichnet** , daß der zweite Zweig (2) mindestens ein Kettenglied (8,11,28, 31) aufweist, das aus der Kettenschaltung einer Schaltungskomponente (6,9,27;30) die eine der frequenzabhängigen quadratischen Übertragungsfunktion ($H_{2b}(\omega_1,\omega_2)$) des zu kompensierenden Verstärkers (B) entsprechende Übertragungsfunktion aufweist, und einer Schaltungskomponente (7,10,26,29), die eine dem inversen linearen Anteil der Übertragungsfunktion ($1/H_{1b}(\omega)$) des zu kompensierenden Verstärkers (B) entsprechende Übertragungsfunktion aufweist, besteht, und/oder der dritte Zweig (3) ein Kettenglied (14,34) aufweist, das aus der Kettenschaltung einer Schaltungskomponente (12,33), die eine dem kubischen Anteil der frequenzabhängigen Übertragungsfunktion ($H_{3b}(\omega_1,\omega_2,\omega_3)$) des zu kompensierenden Verstärkers (B) entsprechende Übertragungsfunktion aufweist, und einer Schaltungskomponente (13,33), die eine dem inversen linearen Anteil der frequenzabhängigen Übertragungsfunktion ($1/H_{1b}(\omega)$)des zu kompensierenden Verstärkers (B) entsprechende Übertragungsfunktion aufweist, besteht.

2. Schaltung nach Anspruch 1 für ein vor dem Verstärker (B) in Kette geschaltetes Hilfssystem (A), dadurch **gekennzeichnet** , daß im zweiten Zweig die Schaltungskomponente (6,9) mit quadratischer Übertragungsfunktion und im dritten Zweig die Schaltungskomponente (12) mit kubischer Übertragungsfunktion jeweils vor den zugehörigen Schaltungskomponenten (7,10,13) mit inverser linearer Übertragungsfunktion angeordnet sind.

3. Schaltung nach Anspruch 1 für ein nach dem Verstärker (B) in Kette angeordnetes Hilfssystem (A), dadurch **gekennzeichnet** , daß im zweiten Zweig die Schaltungskomponente (27,30) mit quadratischer Übertragungsfunktion und im dritten Zweig die Schaltungskomponente (33) mit kubischer Übertragungsfunktion jeweils nach den zugehörigen Schaltungskomponenten (26,29,32) mit inverser linearer Übertragungsfunktion angeordnet sind.

4. Schaltung nach einem der vorhergehenden Ansprüche, dadurch **gekennzeichnet** , daß die Schaltungskomponenten (6,9,27,30,12,33) mit quadratischer bzw. kubischer Übertragungsfunktion so gewählt und dimensioniert sind, daß sie mindestens im gesamten Übertragungsfrequenzband des breitbandig zu kompensierenden Verstärkers (B) die gleiche entsprechende Übertragungsfunktion ($H_{2b}(\omega_1,\omega_2)$ bzw. ($H_{3b}(\omega_1,\omega_2,\omega_3)$)wie der zu kompensierende Verstärker (B) aufweisen.

5. Schaltung nach einem der vorhergehenden Ansprüche zur ausschließlichen Kompensation der quatratischen Verzerrungen eines Verstärkers (B), dadurch **gekennzeichnet**, daß nur ein zweiter Zweig und in diesem nur ein Kettenglied (8,28) vorgesehen ist, das aus der Kettenschaltung einer Schaltungskomponente (6,27) mit quadratischer Übertragungsfunktion und einer Schaltungskomponente (7,26) mit inverser linearer Übertragungsfunktion besteht.

6. Schaltung nach einem der vorhergehenden Ansprüche zur ausschließlichen Kompensation der kubischen Verzerrungen eines Verstärkers (B), dadurch **gekennzeichnet** , daß der zweite Zweig (2) aus der Kettenschaltung von zwei Kettengliedern (8,11,28,31) besteht, die jeweils aus der Kettenschaltung einer Schaltungskomponente (6,9,27,30) mit quadratischer Übertragungsfunktion und einer Schaltungskomponente (7,10,26,29) mit inverser linearer Übertragungsfunktion bestehen, und der dritte Zweig ein Kettenglied (14,34) aufweist, das aus der Kettenschaltung einer Schaltungskomponente (12,33) mit kubischer Übertragungsfunktion und einer Schaltungskomponente (13,32) mit inverser linearer Übertragungsfunktion besteht .

7. Schaltung nach Anspruch 6, dadurch **gekennzeichnet** , daß zur gleichzeitigen Kompensation von quadratischen und kubischen Verzerrungen des Verstärkers (B) entweder das Eingangssignal von der Verzweigungsstelle (4) dem Ausgangssignal des ersten Kettengliedes (8,28) des zweiten Zweiges (2) hinzuaddiert wird oder das Ausgangssignal des ersten Kettengliedes (8,28) des zweiten Zweiges (2) von dem Eingangssignal subtrahiert wird.

8. Schaltung nach Anspruch 7, dadurch **gekennzeichnet** , daß zwischen den beiden Kettengliedern (8,11,28,31) des zweiten Zweiges (2) eine Addierstufe (16) angeordnet ist, die unmittelbar mit der Verzweigungsstelle (4) verbunden ist.

9. Schaltung nach Anspruch 7, dadurch **gekennzeichnet,** daß im ersten Zweig (1) zwischen der Verzweigungsstelle (4) und der Addierstelle (5) eine Addierstufe (18) zwischengeschaltet ist, der das Ausgangssignal des ersten Kettengliedes (8,28) im subtrahierenden Sinne zugeführt ist.

10. Schaltung nach einem der vorhergehenden Ansprüche für einen dem Hilfssystem (A) nachgeschalteten Verstärker (B) dadurch **gekennzeichnet** , daß die inverse lineare Schaltungskomponente (10) des zweiten Kettengliedes (11) des zweiten Zweiges (2) gleichzeitig als die inverse lineare Schaltungskomponente des dritten Zweiges (3) ausgenutzt ist.

11. Schaltung nach einem der vorhergehenden Ansprüche für ein dem Verstärker (B) nachgeschaltetes Hilfssystem (A), dadurch **gekennzeichnet** , daß die inverse lineare Schaltungskomponente (26) des ersten Kettengliedes (28) des zweiten Zweiges gleichzeitig als inverse lineare Schaltungskomponente des dritten Zweiges (3) ausgenutzt ist.

12. Schaltung nach einem der vorhergehenden Ansprüche für ein dem Verstärker (B) vorgeschaltetes Hilfssystem (A) dadurch **gekennzeichnet,** daß vor dem Hilfssystem (A) zusätzlich noch eine Schaltungskomponente (40) von beliebiger linearer Übertragungsfunktion ($H_{1a}(\omega)$) vorgeschaltet ist.

13. Schaltung nach einem der vorhergehenden Ansprüche für ein dem Verstärker (B) vorgeschaltetes Hilfssystem (A) dadurch **gekennzeichnet** , daß nach dem Hilfssystem (A) eine zusätzliche Schaltungskomponente (40) mit beliebiger linearer Übertragungsfunktion ($H_{1a}(\omega)$) nachgeschaltet ist.

14. Schaltung nach einem der vorhergehenden Ansprüche, dadurch **gekennzeichnet** , daß die Schaltungskomponenten (6,9,27,30) mit quadratischer Übertragungsfunktion ($H_{2b}(\omega_1,\omega_2)$)jeweils aus zwei Subkomponenten (43,44) aufgebaut sind, die jeweils identisch die gleiche quadratische Übertragungsfunktion ($H_{2b}(\omega_1,\omega_2)$)wie der zu kompensierende Verstärker aufweisen oder sich lediglich durch einen reellen konstanten Faktor $1/\beta$ von dieser unterscheiden, wobei das Ausgangssignal der ersten Subkomponente (43) zu dem invertierten Ausgangssignal der zweiten Subkomponente (44) addiert wird (Addierstufe 45) und in einer nachgeschalteten dritten Subkomponente (47) mit dem Faktor $\beta/2$ bewertet wird.

15. Schaltung nach Anspruch 14, dadurch **gekennzeicnet,** daß bei Vernachlässigung der kubischen Verzerrungen des Verstärkers (B) die eine Subkomponente (43 oder 44) nur den linearen Anteil ($H_{1b}(\omega)/\alpha$)der Übertragungsfunktion der jeweils anderen Subkomponente (44 bzw. 43) aufweist und die dritte Subkomponente (47) das addierte Ausgangs-signal mit dem Faktor $\beta$ bewertet.

16. Schaltung nach einem der vorhergehenden Ansprüche, dadurch **gekennzeichnet** , daß die Schaltungskomponenten (13,33) mit kubischer Übertragungsfunktion ($H_{3b}(\omega_1,\omega_2,\omega_3)$)des zu kompensierenden Verstärkers (B) zwei Subkomponenten (43,44) aufweisen, die jeweils identisch die gleiche frequenzabhängige Übertragungsfunktion $H_{3b}(\omega_1,\omega_2,\omega_3)$) wie der zu kompensierende Verstärker (B) aufweisen oder sich lediglich durch einen reellen konstanten Faktor $1/\gamma$ von dieser unterscheiden, wobei der ersten Subkomponente (43) die zweite Subkomponente (44) mit einem vorgeschalteten und einem nachgeschalteten Inverter (46,48) parallelgeschaltet ist, die Ausgangssignale dieser beiden Parallelzweige in einer Addierstufe (49) addiert und einer dritten Subkomponente (50) zugeführt werden, die eine zum linearen Anteil ($H_{1b}$) der Übertragungsfunktion der ersten und zweiten Subkomponente (43,44) inverse lineare Übertragungsfunktion ($\alpha/2H_{1b}$) aufweist, wobei von dem Ausgangssignal dieser dritten Subkomponente (50) das Eingangssignal der Gesamtschaltung subtrahiert wird und das so gewonne Differenzsignal einer vierten Subkomponente (52) zugeführt wird, welche dieses Differenzsignal mit dem Faktor $\gamma/2$ bewertet.

17. Schaltung nach Anspruch 16, dadurch **gekennzeichnet,** daß bei Vernachlässigung der quadratischen Verzerrungen des Verstärkers (B) die eine Subkomponente (43 oder 44) nur den linearen Anteil ($H_{1b}(\omega)/\alpha$) der Übertragungsfunktion der jeweils anderen Subkomporiente (44 bzw. 43) aufweist und die dritte Subkomponente (47) das addierte Ausgangssignal mit dem Faktor $\gamma$ bewertet.

18. Schaltung nach einem der vorhergehenden Ansprüche, dadurch **gekennzeichnet** , daß die Schaltungskomponenten (7,10,13,26,29,32,40) mit linearer oder invers-linearer Übertragungsfunktion nach den bekannten Regeln vertauscht oder über Verzweigungsstellen bzw. über Additionsstellen verschoben sind.

## Claims

1. Circuit for compensating the non-linearity of an amplifier (B) with an auxiliary system (A) connected upstream or downstream, comprising a first branch (1), which transmits the input signal (X) from a junction point (4) linearly and with the gain factor 1 to a summing point (5), a second branch (2), which transmits the input signal (X) from the junction point (4) with square distortion inverted to the summing point (5), and/or a third branch (3), which transmits the input signal (X) from the junction point (4) with cubic distortion inverted to the summing point (5), characterised in that the second branch (2) has at least one cascade element (8, 11, 28, 31) comprising the cascade arrangement of a circuit component (6, 9, 27, 30) which has a transfer function corresponding to the frequency-dependent square transfer function ($H_{2b}(\omega_1,\omega_2)$) of the amplifier (B) to be compensated, and a circuit component (7, 10, 26, 29) having a transfer function corresponding to the inverse linear portion of the transfer function ($1/H_{1b}(\omega)$) of the amplifier (B) to be compensated, and/or the third branch (3) has a cascade element (14, 34) comprising the cascade arrangement of a circuit component (12, 33) having a transfer function corresponding to the cubic portion of the frequency-dependent transfer function ($H_{3b}(\omega_1,\omega_2,\omega_3)$) of the amplifier (B) to be compensated, and a circuit component (13, 33) having a transfer function corresponding to the inverse linear portion of the frequency-dependent transfer function ($1/H_{1b}(\omega)$) of the amplifier (B) to be compensated.

2. Circuit according to claim 1 for an auxiliary system (A) cascaded upstream of the amplifier (B), characterised in that in the second branch the circuit component (6, 9) with the square transfer function and in the third branch the circuit component (12) with the cubic transfer function are each arranged upstream of the associated circuit components (7, 10, 13) with the inverse linear transfer function.

3. Circuit according to claim 1 for an auxiliary system (A) cascaded downstream of the amplifier (B), characterised in that in the second branch the circuit component (27, 30) with the square transfer function and in the third branch the circuit component (33) with the cubic transfer function are each arranged downstream of the associated circuit components (26, 29, 32) with the inverse linear transfer function.

4. Circuit according to one of the preceding claims, characterised in that the circuit components (6, 9, 27, 30, 12, 33) with the square and cubic transfer functions respectively are so selected and dimensioned that they exhibit the same corresponding transfer function, ($H_{2b}(\omega_1,\omega_2)$) and ($H_{3b}(\omega_1,\omega_2,\omega_3)$) respectively, as the amplifier (B) to be compensated, at least in the entire transmission frequency band of the amplifier (B) to be compensated over a wide band.

5. Circuit according to one of the preceding claims for exclusive compensation of the square distortions of an amplifier (B), characterised in that only a second branch and therein only one cascade element (8, 28) is provided, which comprises the cascade arrangement of a circuit component (6, 27) with a square transfer function and a circuit component (7, 26) with an inverse linear transfer function.

6. Circuit according to one of the preceding claims for exclusive compensation of the cubic distortions of an amplifier (B), characterised in that the second branch (2) comprises the cascade arrangement of two cascade elements (8, 11, 28, 31), each consisting of the cascaded arrangement of a circuit component (6, 9, 27, 30) with a square transfer function and a circuit component (7, 10, 26, 29) with an inverse linear transfer function, and the third branch has a cascade element (14, 34) comprising the cascade arrangement of a circuit component (12, 33) with a cubic transfer function and a circuit component (13, 32) with an inverse linear transfer function.

7. Circuit according to claim 6, characterised in that for simultaneous compensation of square and cubic distortions of the amplifier (B), either the input signal of the junction point (4) is added to the output signal of the first cascade element (8, 28) of the second branch (2), or the output signal of the first cascade element (8, 28) of the second branch (2) is subtracted from the input signal.

8. Circuit according to claim 7, characterised in that between the two cascade elements (8, 11, 28, 31) of the second branch (2) there is arranged a summing stage (16) connected direct to the junction point (4).

9. Circuit according to claim 7, characterised in that in the first branch (1) between the junction point (4) and the summing point (5) there is interposed a summing stage (18) to which the output signal of the first cascade element (8, 28) is passed for subtraction.

10. Circuit according to one of the preceding claims for an amplifier (B) connected downstream of the auxiliary system (A), characterised in that the inverse linear circuit component (10) of the second cascade element (11) of the second branch (2) is simultaneously used as the inverse linear circuit component of the third branch (3).

11. Circuit according to one of the preceding claims for an auxiliary system (A) connected downstream of the amplifier (B), characterised in that the inverse linear circuit component (26) of the first cascade element (28) of the second branch is simultaneously used as the inverse linear circuit component of the third branch (3).

12. Circuit according to one of the preceding claims for an auxiliary system (A) connected upstream of the amplifier (B), characterised in that upstream of the auxiliary system (A) there is additionally connected a further circuit component (40) with any desired linear transfer function ($H_{1a}(\omega)$).

13. Circuit according to one of the preceding claims for an auxiliary system (A) connected upstream of the amplifier (B), characterised in that downstream of the auxiliary system (A) there is connected an additional circuit component (40) with any desired linear transfer function ($H_{1a}(\omega)$).

14. Circuit according to one of the preceding claims, characterised in that the circuit components (6, 9, 27, 30) with the square transfer function ($H_{2b}(\omega_1,\omega_2)$) are each assembled from two subcomponents (43, 44), each of which identically have the same square transfer function ($H_{2b}(\omega_1,\omega_2)$) as the amplifier to be compensated, or which merely differ therefrom by a real constant factor $1/\beta$, the output signal of the first subcomponent (43) being added to the inverted output signal of the second subcomponent (44) (summing stage 45) and weighted by the factor $\beta/2$ in a downstream third subcomponent (47).

15. Circuit according to claim 14, characterised in that if the cubic distortions of the amplifier (B) are disregarded, one subcomponent (43 or 44) exhibits only the linear portion ($H_{1b}(\omega)/\alpha$) of the transfer function of the respective other subcomponent (44 or 43) and the third subcomponent (47) weights the summed output signal by the factor $\beta$.

16. Circuit according to one of the preceding claims, characterised in that the circuit components (13, 33) with the cubic transfer function ($H_{3b}(\omega_1,\omega_2,\omega_3)$) of the amplifier (B) to be compensated exhibit two subcomponents (43, 44), each of which identically has the same frequency-dependent transfer function ($H_{3b}(\omega_1,\omega_2,\omega_3)$) as the amplifier (B) to be compensated or differs therefrom merely by a real constant factor $1/\gamma$, the second subcomponent (44) being connected in parallel to the first subcomponent (43) with one downstream and one upstream inverter (46, 48), the output signals of these two parallel branches being summed in a summing stage (49) and passed to a third subcomponent (50) exhibiting a linear transfer function ($\alpha/2H_{1b}$) inverse to the linear portion ($H_{1b}$) of the transfer function of the first and second subcomponent (43, 44), the input signal of the overall circuit being subtracted from the output signal of this third subcomponent (50) and the resulting signal differential being passed to a fourth subcomponent (52) which weights said signal differential by the factor $\gamma/2$.

17. Circuit according to claim 16, characterised in that if the square distortions of the amplifier (B) are disregarded, one subcomponent (43 or 44) exhibits only the linear portion ($H_{1b}(\omega)/\alpha$) of the transfer function of the respective other subcomponent (44 or 43) and the third subcomponent (47) weights the summed output signal by the factor $\gamma$.

18. Circuit according to one of the preceding claims, characterised in that the circuit components (7, 10, 13, 26, 29, 32, 40) with linear or inverse linear transfer functions are interchanged or shifted via junction points or via summing points in accordance with the conventional rules.

## Revendications

1. Circuit de compensation du défaut de linéarité d'un amplificateur (B) avec un système auxiliaire (A) en amont ou en aval, circuit composé d'une première branche (1) qui transmet le signal d'entrée (X) d'un point de dérivation (4), de manière linéaire et avec un coefficient d'amplification égal à 1 vers un point d'addition (5), selon une branche (2) qui transmet le signal d'entrée (X) du point de dérivation (4) avec distorsion carrée inverse vers le point d'addition (5) et/ou une troisième branche (3) qui transmet le signal d'entrée (X) du point de dérivation (4) avec distorsion cubique inverse vers le point d'addition (5), circuit caractérisé en ce que la seconde branche (2) comporte au moins un élément série (8, 11, 28, 31) formé du montage en série d'un composant (6, 9, 27, 30) ayant une fonction de transfert carré ($H_{2b}(\omega_1,\omega_2)$) dépendant de la fréquence correspondant à la fonction de transfert de l'amplificateur (B) à compenser, ainsi qu'un composant (7, 10, 26, 29) ayant une fonction de transfert correspondant à la partie de lumière inverse de la fonction de transfert ($1/H_{1b}(\omega)$) correspondant à la fonction de transfert de l'amplificateur (B) à compenser et/ou une troisième branche (3) avec un élément série (14, 34) qui se compose du montage en série d'un composant de circuit (12, 33) ayant une fonction de transfert correspondant à la fonction de transfert ($H_{3b}(\omega_1,\omega_2,\omega_3)$) dépendant de la fréquence, correspondant à la partie cubique de l'amplificateur (B) à compenser et un composant de circuit (13, 33) ayant une fonction de transfert correspondant à la partie linéaire inverse de la fonction de transfert dépendant de la fréquence ($1/H_{1b}(\omega)$) de l'amplificateur (B) à compenser.

2. Circuit selon la revendication 1 pour un circuit auxiliaire (A) branché en série en amont de l'amplificateur (B), caractérisé en ce la seconde branche contient les composants de circuit (6, 9) à fonction de transfert carré et la troisième branche contient les composants de circuit (12) à fonction de transfert cubique, chaque fois en amont des composants de circuit correspondant (7, 10, 13) à fonction de transfert linéaire inverse.

3. Circuit selon la revendication 1 pour un système auxiliaire (A) en série en aval de l'amplificateur (B), caractérisé en ce que la seconde branche contient les composants de circuit (27, 30) à fonction de transfert carré et la troisième branche contient les composants de circuit (33) à fonction de transfert cubique, chaque fois en aval des composants de circuit correspondant (26, 29, 32) à fonction de transfert linéaire inverse.

4. Circuit selon l'une des revendications précédentes, caractérisé en ce que les composants (6, 9, 27, 30, 12, 33) à fonction de transfert carré ou cubique sont choisis et dimensionnés pour qu'au moins dans toute la bande de fréquence de transfert de l'amplificateur (B) à compenser en bande large, il présente une fonction de transfert correspondant ($H_{2b}(\omega_1,\omega_2)$ ou ($H_{3b}(\omega_1,\omega_2,\omega_3)$)) correspondant à celle de l'amplificateur (B) que l'on veut compenser.

5. Circuit selon l'une des revendications précédentes pour la compensation exclusive des distorsions carrées d'un amplificateur (B), caractérisé en ce qu'il ne comporte qu'une seconde branche et dans celle-ci seulement un élément série (8, 28) qui est formé du montage en série d'un composant de circuit (6, 27) à fonction de transfert carré et d'un composant de circuit (7, 26) à fonction de transfert linéaire inverse.

6. Circuit selon l'une des revendications précédentes pour la compensation exclusive des distorsions cubiques d'un amplificateur (B), caractérisé en ce que la seconde branche (2) est formée du montage en série de deux éléments série (8, 11, 28, 31) qui se composent respectivement du montage en série d'un composant de circuit (6, 9, 27, 30) à fonction de transfert carré et d'un composant de circuit (7, 10, 26, 29) à fonction de transfert linéaire inverse et en ce que la troisième branche comprend un composant série (14, 34) formé du montage en série d'un composant de circuit (12, 33) à fonction de transfert cubique et d'un composant de circuit (13, 32) à fonction de transfert linéaire inverse.

7. Circuit selon la revendication 6, caractérisé en ce que pour compenser simultanément des distorsions carrées et cubiques de l'amplificateur (B) on ajoute le signal d'entrée du point de dérivation (4) au signal de sortie du premier élément en série (8, 28) de la seconde branche (2) ou on retranche le signal de sortie du premier élément série (8, 28) de la seconde branche (2) du signal d'entrée.

8. Circuit selon la revendication 7, caractérisé en ce qu'entre les deux éléments série (8, 11, 28, 31) de la seconde branche (2) on a un étage additionneur (16) qui est directement relié au point de dérivation (4).

9. Circuit selon la revendication 7, caractérisé en ce que la première branche (1) comporte entre le point de dérivation (4) et le point d'addition (5), un étage d'addition (18) qui reçoit le signal de sortie du premier élément série (8, 28) dans le sens de la soustraction.

10. Circuit selon l'une des revendications précédentes pour un système auxiliaire (A) monté en aval d'un amplificateur (B), caractérisé en ce que le composant de circuit (10), linéaire inverse du second élément série (11) de la seconde branche (2) est utilisé en même temps comme composant de circuit linéaire inverse de la troisième branche (3).

11. Circuit selon l'une des revendications précédentes pour un système auxiliaire (A) en aval de l'amplificateur (B), caractérisé en ce que le composant de circuit (26) linéaire inverse du premier élément série (28) de la seconde branche est utilisé en même temps comme composant de circuit linéaire inverse de la troisième branche (3).

12. Circuit selon l'une des revendications précédentes pour un système auxiliaire (A) en amont de l'amplificateur (B), caractérisé en ce qu'en amont du système auxiliaire (A) il est en outre prévu un composant de circuit (40) à fonction de transfert linéaire quelconque ($H_{1a}(\omega)$).

13. Circuit selon l'une des revendications précédentes pour un système auxiliaire (A) en amont de l'amplificateur (B), caractérisé en ce qu'après le système auxiliaire (A) on a un composant de circuit (40), supplémentaire à fonction de transfert linéaire quelconque ($H_{1a}(\omega)$).

14. Circuit selon l'une des revendications précédentes, caractérisé en ce que les composants de circuit (6, 9, 27, 30) à fonction de transfert carré ($H_{2b}(\omega_1,\omega_2)$) sont chaque fois réalisés de deux sous-composants (43, 44), qui ont chaque fois de manière identique, la même fonction de transfert carré ($H_{2b}(\omega_1,\omega_2)$) que l'amplificateur à compenser ou encore s'en distingue par un coefficient constant réel $1/\beta$ et le signal de sortie du premier sous-composant (43) est ajouté au signal de sortie inverse du second sous-composant (44) (étage additionneur 45) et est exploité avec un coefficient $\beta/2$ dans un troisième sous-composant (47) en aval.

15. Circuit selon la revendication 14, caractérisé en ce qu'en négligeant les distorsions cubiques de l'amplificateur (B), un sous-composant (43 ou 44) ne présente que la partie linéaire ($H_{1b}(\omega)/\alpha$) de la fonction de transfert de l'autre sous-composant (44 ou 43) et le troisième sous-composant (47) exploite le signal de sortie ajouté avec le coefficient $\beta$.

16. Circuit selon l'une des revendications précédentes, caractérisé en ce que les composants de circuit (13, 33) à fonction de transfert cubique ($H_{3b}(\omega_1,\omega_2,\omega_3)$) de l'amplificateur (B) à compenser présentent deux sous-composantes (43, 44) qui ont respectivement de manière identique la même fonction de transfert dépendant de la fréquence ($H_{3b}(\omega_1,\omega_2,\omega_3)$) que l'amplificateur (B) à compenser ou s'en distingue uniquement par un coefficient constant réel $1/\gamma$, le premier sous-composant (43) ayant en parallèle le second sous-composant (44) avec un inverseur (46, 48) en amont et en aval, les signaux de sortie de ces deux branches en parallèle étant additionnés dans un étage additionneur (49) pour être appliqués à un troisième sous-composant (50) qui présente une fonction de transfert linéaire inverse ($\alpha/2H_{1b}$) par rapport à la partie linéaire ($H_{1b}$) de la fonction de transfert du premier et du second sous-composant (43, 44), et on retranche du signal de sortie de ce troisième sous-composant (50), le signal d'entrée du circuit d'ensemble et le signal de différence ainsi obtenus est appliqué à un quatrième sous-composant (52) qui exploite ce signal de différence avec le coefficient $\gamma/2$.

17. Circuit selon la revendication 16, caractérisé en ce qu'en négligeant les distorsions carrées de l'amplificateur (B), un sous-composant (43 ou 44) ne présente que la partie linéaire ($H_{1b}(\omega)/\alpha$) de la fonction de transfert de l'autre sous-composant respectif (44, 43) et le troisième sous-composant (47) exploite le signal de sortie d'addition avec le coefficient $\gamma$.

18. Circuit selon l'une des revendications précédentes, caractérisé en ce que les composants de circuit (7, 10, 13, 26, 29, 32, 40) sont décalés avec une fonction de transfert linéaire ou linéaire inverse selon les règles connues ou par les points de dérivation ou d'addition.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18